# FASCICULE DE BREVET EUROPEEN

(11) **EP 4 550 823 B1**
(45) Date de publication et mention de la délivrance du brevet: **25.02.2026**
(21) Numéro de dépôt: 24209396.1
(22) Date de dépôt: 29.10.2024
(51) Int. Cl.: H04Q 9/04, G01D 4/00

(54) **SYNCHRONISATION D'HORLOGE PAR LIAISON SERIE**
TAKTSYNCHRONISIERUNG DURCH SERIELLE VERBINDUNG
CLOCK SYNCHRONIZATION OVER A SERIAL LINK

(30) Priorité: 30.10.2023 FR 2311788
(43) Date de publication de la demande: 07.05.2025
(73) Titulaire: SAGEMCOM ENERGY & TELECOM SAS, 92270 Bois-Colombes (FR)
(72) Inventeur: JEANROT, Marc, 92270 Bois-Colombes (FR); GRINCOURT, Christophe, 92270 Bois-Colombes (FR)
(74) Mandataire: Cabinet Boettcher

(56) Documents cités:
- FR-A1- 3 119 039
- US-B2- 11 662 475

## Description

L'invention concerne le domaine des compteurs électriques, et notamment des compteurs industriels.

### ARRIERE PLAN DE L'INVENTION

Certains compteurs électriques industriels modernes sont conçus pour mesurer, en plus de la consommation d'énergie électrique de l'installation à laquelle ils sont raccordés, des paramètres de qualité de l'alimentation fournie par le réseau de distribution d'énergie électrique.

Les paramètres de qualité de l'alimentation comprennent notamment la fréquence et l'amplitude de la tension d'alimentation, les creux, les surtensions, les coupures de tension, le déséquilibre de tension, etc.

La Commission Electrotechnique Internationale (IEC) a produit la norme de qualimétrie IEC 61000-4-30 qui définit la manière de mesurer ces paramètres.

Pour être conformes à la norme IEC 61000-4-30 classe A, les compteurs électriques doivent posséder une horloge très précise qui leur permet d'horodater très précisément la survenue des différents événements sur le réseau.

L'horodatage très précis des évènements permet notamment, en analysant les données de plusieurs compteurs, de connaître à quel endroit du réseau l'événement est apparu.

Cette horloge ne doit pas dériver de plus d'une période réseau par rapport à l'heure UTC (pour *Coordinated Universal Time,* que l'on traduit par temps universel coordonné), ce qui correspond, pour une fréquence de la tension d'alimentation de 60 Hz, à +/- 16,67 ms.

Or, les horloges internes des compteurs ont une dérive naturelle liée principalement aux oscillateurs. Il convient donc de resynchroniser régulièrement les compteurs à l'heure UTC.

Afin de réaliser la synchronisation horaire, certains compteurs actuels sont équipés d'un signal *hardware* (entrée Tout Ou Rien) souvent appelé « signal TOP SYNCHRO », permettant à une horloge de référence (ayant accès à l'heure UTC) de synchroniser l'horloge interne du compteur. Cette solution nécessite donc un port dédié, ce qui augmente le coût du compteur.

Le document US 11 662 475 B2 décrit un procédé d'horodatage d'une ou de plusieurs mesures de capteur asynchrones dans un système global de navigation par satellite. Les données de mesure de capteur sont reçues au niveau d'un premier port. Une impulsion de signal, représentant un moment de mesure, est reçue au niveau d'un second port.

D'autres compteurs embarquent un serveur NTP (pour *Network Time Protocol,* que l'on traduit par protocole de temps réseau) permettant cette synchronisation, soit au travers d'un lien radio (GPS), soit via un lien filaire avec le protocole IEEE 1588 (liaison Ethernet).

Ces solutions ont tendance à ne plus être acceptées par les distributeurs d'énergie voire même par les abonnés, car elles sont facilement « piratables ». Ces solutions sont par ailleurs relativement onéreuses.

### OBJET DE L'INVENTION

L'invention a pour objet de resynchroniser l'horloge interne d'un compteur électrique, de manière simple, peu coûteuse et sécurisée.

### RESUME DE L'INVENTION

En vue de la réalisation de ce but, on propose un procédé de synchronisation d'une horloge interne d'un compteur électrique qui comporte une première unité de traitement comprenant un premier port agencé pour être connecté à un équipement externe, le procédé de synchronisation comprenant les premières étapes, mises en œuvre successivement par la première unité de traitement et répétées à intervalles prédéfinis, de :
∘ recevoir via le premier port une première trame émise par l'équipement externe en utilisant une liaison série, et contenant une heure de référence ;
∘ configurer le premier port pour qu'il fonctionne dans un mode de déclenchement d'interruption ;
∘ recevoir via le premier port une impulsion, émise par l'équipement externe et définissant un temps de synchronisation, et déclencher une interruption conduisant à enregistrer l'heure de référence comme étant une heure courante au temps de synchronisation ;
∘ reconfigurer le premier port pour communiquer via le premier port en utilisant la liaison série.

La synchronisation de l'horloge interne du compteur électrique est donc réalisée par un équipement externe au compteur, un modem par exemple, via la liaison série. On peut donc utiliser une liaison série préexistante, de sorte que la mise en œuvre du procédé de synchronisation ne nécessite pas de connexion supplémentaire et est simple et peu onéreuse à réaliser. Cette liaisons série est difficilement piratable.

On propose de plus un procédé de synchronisation tel que précédemment décrit, dans lequel les premières étapes comprennent de plus l'étape, suite à la réception de la première trame, d'émettre via le premier port, à destination de l'équipement externe et en utilisant la liaison série, une deuxième trame contenant un message d'acquittement.

On propose de plus un procédé de synchronisation tel que précédemment décrit, dans lequel une durée entre l'émission de la première trame et l'émission de la deuxième trame est une durée prédéfinie comprise entre 1 s et 3 s.

On propose de plus un procédé de synchronisation tel que précédemment décrit, dans lequel les premières étapes comprennent de plus l'étape, suite à la reconfiguration du premier port, d'émettre via le premier port, à destination de l'équipement externe et en utilisant la liaison série, une troisième trame contenant une information de fin de mise à l'heure.

On propose de plus un procédé de synchronisation tel que précédemment décrit, dans lequel l'interruption est une interruption sur front montant.

On propose de plus un procédé de synchronisation tel que précédemment décrit, dans lequel la liaison série est une liaison RS-232.

On propose de plus un compteur électrique comprenant une première unité de traitement comportant un premier port, dans laquelle sont mises en œuvre les premières étapes du procédé de synchronisation tel que précédemment décrit.

On propose de plus un compteur électrique tel que précédemment décrit, le compteur électrique étant en outre agencé pour surveiller un réseau de distribution d'énergie électrique auquel il est connecté, pour horodater des évènements survenant sur le réseau de distribution d'énergie électrique en utilisant l'heure courante, et pour transmettre à l'équipement externe des informations de surveillance du réseau en utilisant la liaison série.

On propose de plus un programme d'ordinateur comprenant des instructions qui conduisent la première unité de traitement du compteur électrique tel que précédemment décrit à exécuter les premières étapes du procédé de synchronisation tel que précédemment décrit.

On propose de plus un support d'enregistrement lisible par ordinateur, sur lequel est enregistré le programme d'ordinateur tel que précédemment décrit.

On propose de plus un procédé de synchronisation d'une horloge interne d'un compteur électrique agencé pour être connecté à un équipement externe qui comprend une deuxième unité de traitement comportant un deuxième port agencé pour être connecté au compteur électrique, le procédé de synchronisation comprenant les deuxièmes étapes, mises en œuvre successivement par la deuxième unité de traitement et répétées à intervalles prédéfinis, de :
∘ émettre via le deuxième port, à destination du compteur électrique et en utilisant une liaison série, une première trame contenant une heure de référence ;
∘ configurer le deuxième port pour qu'il fonctionne dans un mode de génération d'impulsions ;
∘ émettre via le deuxième port, à destination du compteur électrique, une impulsion définissant un temps de synchronisation ;
∘ reconfigurer le deuxième port pour communiquer via le deuxième port en utilisant la liaison série.

On propose de plus un procédé de synchronisation tel que précédemment décrit, dans lequel l'impulsion a une durée définie avec une précision de +/- 1 ms.

On propose de plus un procédé de synchronisation tel que précédemment décrit, dans lequel les deuxièmes étapes comprennent de plus l'étape, suite à l'émission de la première trame, d'attendre, avant de configurer le deuxième port pour qu'il fonctionne dans le mode de génération d'impulsions, de recevoir via le deuxième port une deuxième trame contenant un message d'acquittement.

On propose de plus un modem comprenant une deuxième unité de traitement comportant un deuxième port, dans laquelle sont mises en œuvre les deuxièmes étapes du procédé de synchronisation tel que précédemment décrit.

On propose de plus un programme d'ordinateur comprenant des instructions qui conduisent la deuxième unité de traitement du modem tel que précédemment décrit à exécuter les deuxièmes étapes du procédé de synchronisation tel que précédemment décrit.

On propose de plus un support d'enregistrement lisible par ordinateur, sur lequel est enregistré le programme d'ordinateur tel que précédemment décrit.

On propose de plus un système comprenant un compteur électrique tel que précédemment décrit, et un modem tel que précédemment décrit.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés parmi lesquels :
[Fig. 1] la figure 1 représente un système comprenant un compteur électrique et un modem ;
[Fig. 2] la figure 2 illustre une phase de synchronisation de l'horloge du compteur ;
[Fig. 3] la figure 3 représente les étapes d'une phase de synchronisation.

### DESCRIPTION DETAILLEE DE L'INVENTION

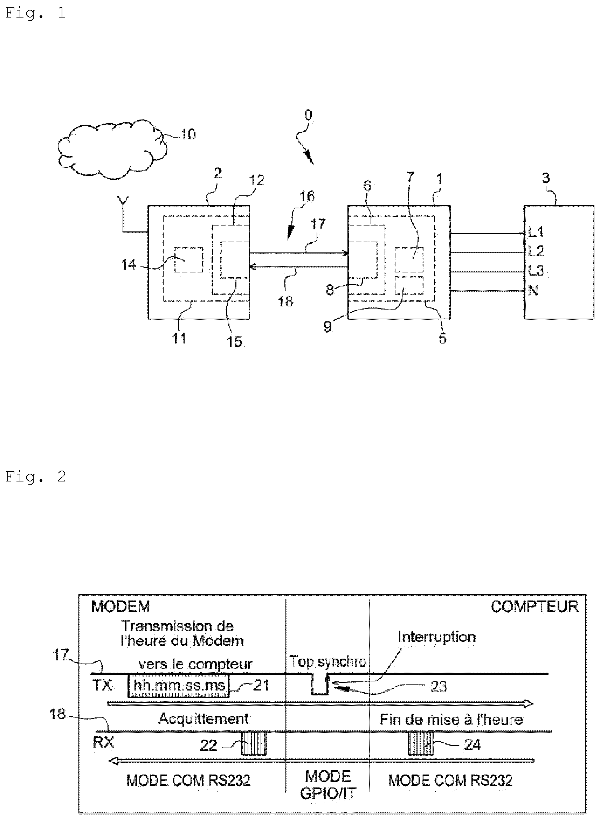

En référence à la figure 1, le système 0 comprend un compteur 1 et un équipement externe au compteur 1, en l'occurrence un modem 2.

Le compteur 1 est un compteur électrique industriel qui est ici connecté à un réseau de distribution d'énergie électrique 3 qui est un réseau triphasé et qui comprend une première phase L1, une deuxième phase L2, une troisième phase L3 et un neutre N.

Le compteur électrique 1 est raccordé à une installation électrique industrielle, à laquelle le réseau 3 fournit de l'énergie électrique.

Le compteur 1 est de plus connecté au modem 2.

Le compteur 1 comporte une première unité de traitement 5.

La première unité de traitement 5 est ici conçue, classiquement, pour acquérir et pour traiter des mesures de courant et de tension réalisées par les capteurs du compteur 1, de manière à mesurer l'énergie électrique consommée par l'installation.

La première unité de traitement 5 est aussi conçue pour mesurer des paramètres de qualité de l'alimentation fournie par le réseau 3, et pour horodater des évènements survenant sur le réseau 3.

La première unité de traitement 5 comprend au moins un premier composant de traitement 6.

Le premier composant de traitement 6 est par exemple un processeur « généraliste », un microcontrôleur, un processeur spécialisé dans le traitement du signal (ou DSP, pour *Digital Signal Processor),* ou bien un circuit logique programmable tel qu'un FPGA (pour *Field Programmable Gate Arrays)* ou un ASIC (pour *Application Specific Integrated Circuit*)*.*

Le premier composant de traitement 6 est ici un microcontrôleur.

La première unité de traitement 5 comprend de plus une ou des mémoires 7, reliées à ou intégrées dans le premier composant de traitement 6. Au moins l'une de ces mémoires 7 forme un support d'enregistrement lisible par ordinateur, sur lequel est enregistré au moins un programme d'ordinateur comprenant des instructions qui conduisent le premier composant de traitement 6 à exécuter les premières étapes des phases de synchronisation qui vont être décrites.

La première unité de traitement 5 comporte au moins un premier port 8, qui peut être configuré selon un mode de communication série, dans lequel le premier port 8 peut être utilisé pour mettre en œuvre une liaison série (ici RS-232), et dans un mode de déclenchement d'interruption.

Le premier port 8 est un port du premier composant de traitement 6 et comprend deux pattes *(pins)* du premier composant de traitement 6.

Le premier port 8 est ici un port configurable en mode UART (pour *Universal Asynchronous Receiver Transmitter)* ou en mode GPIO (pour *General Purpose Input*/*Output,* que l'on peut traduire par Entrée-Sortie à usage général).

Ainsi, ici, le mode de communication série correspond au mode UART, et le mode de déclenchement d'interruption correspond au mode GPIO.

La première unité de traitement 5 comprend aussi une horloge interne 9, qui est utilisée notamment pour horodater les évènements évoqués plus tôt survenant sur le réseau de distribution 3.

Le modem 2 est quant à lui conçu pour former une interface de communication entre le compteur 1 (et éventuellement d'autres compteurs) et un réseau de communication 10 (le réseau internet par exemple). Le compteur 1 communique donc avec le réseau 10 via le modem 2.

Le modem 2 a accès à l'heure UTC grâce à sa connexion avec le réseau 10.

Le modem 2 comporte une deuxième unité de traitement 11 comprenant au moins un deuxième composant de traitement 12.

Le deuxième composant de traitement 12 est par exemple un processeur « généraliste », un microcontrôleur, un processeur spécialisé dans le traitement du signal (ou DSP, pour *Digital Signal Processor),* ou bien un circuit logique programmable tel qu'un FPGA (pour *Field Programmable Gate Arrays)* ou un ASIC (pour *Application Specific Integrated Circuit*)*.*

Le deuxième composant de traitement 12 est ici un microcontrôleur.

La deuxième unité de traitement 11 comprend de plus une ou des mémoires 14, reliées à ou intégrées dans le deuxième composant de traitement 12. Au moins l'une de ces mémoires 14 forme un support d'enregistrement lisible par ordinateur, sur lequel est enregistré au moins un programme d'ordinateur comprenant des instructions qui conduisent le deuxième composant de traitement 12 à exécuter les deuxièmes étapes des phases de synchronisation qui vont être décrites.

La deuxième unité de traitement 11 comporte au moins un deuxième port 15, qui peut être configuré selon un mode de communication série, dans lequel le deuxième port 15 peut être utilisé pour mettre en œuvre la liaison série (ici RS-232), et un mode de génération d'impulsions, permettant de générer des interruptions dans la première unité de traitement 5 depuis l'extérieur du compteur 1.

Le deuxième port 15 est un port du deuxième composant de traitement 12 et comprend deux pattes *(pins)* du deuxième composant de traitement 12.

Le deuxième port 15 est un port configurable en mode UART ou en mode GPIO.

Ainsi, ici, le mode de communication série correspond au mode UART, et le mode de génération d'impulsions correspond au mode GPIO.

Le premier port 8 du compteur 1 et le deuxième port 15 du modem 2 sont connectés par un câble 16 comprenant deux fils 17, 18 reliant chacun une patte du premier port 8 à une patte du deuxième port 15.

Lorsque le premier port 8 et le deuxième port 15 sont configurés dans le mode de communication série, le compteur 1 et le modem 2 échangent des données en utilisant la liaison série RS-232, via le premier port 8, le deuxième port 15 et les fils 17, 18. Le modem 2 transmet des données au compteur 1 via le fil 17, et le compteur 1 transmet des données au modem 2 via le fil 18.

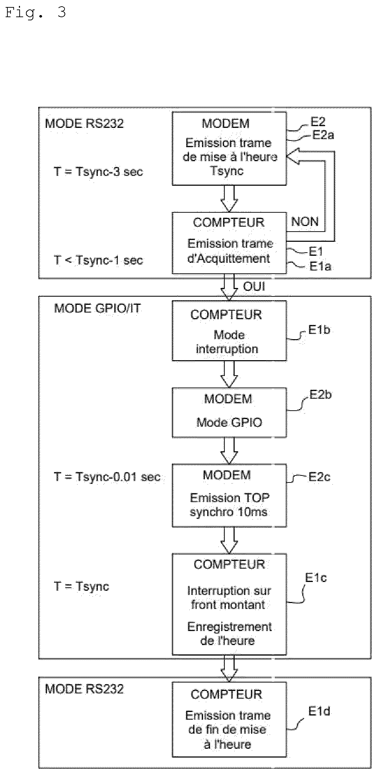

Régulièrement, en référence aux figures 2 et 3, le modem 2 déclenche la synchronisation de l'horloge interne 9 du compteur 1 sur l'heure UTC.

La phase de synchronisation est répétée à intervalles prédéfinis (fixes ou variables), par exemple chaque jour ou chaque semaine.

Chaque phase de synchronisation comprend des premières étapes E1, mises en œuvre successivement par la première unité de traitement 5 du compteur électrique 1, et des deuxièmes étapes E2, mises en œuvre successivement par la deuxième unité de traitement 11 du modem 2.

Les premières étapes E1 et les deuxièmes étapes E2 sont donc répétées aux intervalles prédéfinis.

Chaque phase de synchronisation débute alors que le premier port 8 et le deuxième port 15 sont dans le mode de communication série.

Le modem 2 acquiert sur le réseau 10 l'heure UTC et produit à partir de l'heure UTC une heure de référence correspondant à l'heure courante à un temps de synchronisation Tsync.

Puis, à un temps prédéfini précédant le temps Tsync, par exemple à Tsync - 3 s, la deuxième unité de traitement 11 du modem 2 émet via le deuxième port 15, à destination du compteur 1 et en utilisant la liaison série, une première trame 21 contenant l'heure de référence : étape E2a.

L'heure de référence est par exemple exprimée en heures, minutes, secondes, et millisecondes, et par exemple au format :
hh.mm.ss.ms
avec h pour heure, m pour minute, s pour seconde, ms pour milliseconde.

La première unité de traitement 5 du compteur 1 reçoit alors la première trame 21 via le premier port 8.

Suite à la réception de la première trame 21, le compteur 1 émet via le premier port 8, à destination du modem 2 et en utilisant la liaison série, une deuxième trame 22 contenant un message d'acquittement : étape E1a.

La durée entre l'émission de la première trame 21 et l'émission de la deuxième trame 22 est égale à une durée prédéfinie, qui est comprise par exemple entre 1 s et 3 s.

Ici, cette durée prédéfinie est inférieure à une durée maximale de par exemple 2s.

La deuxième trame 22 est émise à un temps précédant Tsync d'une durée de par exemple 1 s.

Ce « *timeout* » de 2 s (par exemple) est ajouté pour ne pas bloquer la communication RS-232.

Tant que cette trame d'acquittement 22 n'est pas émise, le modem 2 réémet la première trame 21 contenant l'heure de référence.

Après avoir émis la deuxième trame 22, la première unité de traitement 5 du compteur 1 configure le premier port 8 pour qu'il fonctionne en mode interruption : étape E1b.

La deuxième unité de traitement 11 du modem 2 configure le deuxième port 15 pour qu'il fonctionne dans le mode de génération d'impulsions : étape E2b.

La deuxième unité de traitement 11 émet alors via le deuxième port 15, à destination du compteur 1, une impulsion 23 : étape E2c.

Cette impulsion 23 débute par un front descendant et s'achève par un front montant. L'impulsion est calibrée de manière très précise. Elle a une durée définie avec une précision de +/- 1 ms. Cette durée est ici de 10 ms.

L'impulsion 23 définit le temps de synchronisation, qui correspond ici au front montant. L'impulsion 23 est donc émise au temps :
Tsync - 10 ms.

La première unité de traitement 5 reçoit alors via le premier port 8 cette impulsion 23, et déclenche une interruption conduisant à enregistrer l'heure de référence comme étant l'heure courante au temps de synchronisation : étape E1c.

L'interruption est ici une interruption sur front montant.

La première unité de traitement 5 reconfigure le premier port 8 pour communiquer via le premier port 8 en utilisant la liaison série (mode de communication série). Le modem 2 reconfigure le deuxième port 15 pour communiquer via le deuxième port 15 en utilisant la liaison série (mode de communication série).

La première unité de traitement 5 émet alors via le premier port 8, à destination du modem 2 et en utilisant la liaison série, une troisième trame 24 contenant une information de fin de mise à l'heure : étape E1d.

La synchronisation s'achève.

L'horloge 9 du compteur 1 est resynchronisée. L'heure courante est extrêmement précise. Sa précision dépend principalement de la précision de la définition du temps Tsync et donc de la précision de la durée de l'impulsion 23 qui comme on l'a vu, a été calibrée très précisément.

Le compteur 1 surveille ainsi le réseau de distribution d'énergie électrique 3 auquel il est connecté, et, en particulier, horodate très précisément des évènements survenant sur le réseau de distribution 3 en utilisant l'heure courante. Le compteur 1 produit à partir de cette surveillance des informations de surveillance du réseau 3 (comprenant les évènements horodatés), et transmet au modem 2 les informations de surveillance du réseau 3 via le câble 16 en utilisant la liaison série.

Bien entendu, l'invention n'est pas limitée au mode de réalisation décrit mais englobe toute variante entrant dans le champ de l'invention tel que défini par les revendications.

La liaison série n'est pas nécessairement une liaison RS-232, il pourrait s'agir d'un autre type de liaison série, par exemple RS-485.

Le temps de synchronisation est défini par l'interruption (et donc l'impulsion), mais il pourrait s'agir d'un temps autre que celui d'un front montant (et par exemple celui d'un front descendant, ou bien un temps défini par une durée prédéterminée suivant l'interruption).

Les durées citées ici (2 s, 10 ms, etc.) pourraient être différentes.

L'équipement relié au compteur n'est pas nécessairement un modem, il peut s'agir de tout équipement pouvant être connecté à un compteur par une liaison série et ayant accès à l'heure UTC (par exemple un concentrateur de données).

L'étape d'émission de la deuxième trame n'est pas obligatoire : le modem pourrait émettre l'impulsion générant l'interruption sans attendre d'acquittement. De même, l'étape d'émission de la troisième trame n'est pas obligatoire.

L'invention peut être mise en œuvre avec un compteur monophasé ou polyphasé (quel que soit le nombre de phases).

## Revendications

1. Procédé de synchronisation d'une horloge interne (9) d'un compteur électrique (1) qui comporte une première unité de traitement (5) comprenant un premier port (8) agencé pour être connecté à un équipement externe (2), le procédé de synchronisation comprenant les premières étapes (E1), mises en œuvre successivement par la première unité de traitement (5) et répétées à intervalles prédéfinis, de :
∘ recevoir via le premier port (8) une première trame (21) émise par l'équipement externe en utilisant une liaison série, et contenant une heure de référence ;
∘ configurer le premier port pour qu'il fonctionne dans un mode de déclenchement d'interruption ;
∘ recevoir via le premier port une impulsion (23), émise par l'équipement externe et définissant un temps de synchronisation, et déclencher une interruption conduisant à enregistrer l'heure de référence comme étant une heure courante au temps de synchronisation ;
∘ reconfigurer le premier port pour communiquer via le premier port en utilisant la liaison série.

2. Procédé de synchronisation selon la revendication 1, dans lequel les premières étapes comprennent de plus l'étape, suite à la réception de la première trame (21), d'émettre via le premier port (8), à destination de l'équipement externe et en utilisant la liaison série, une deuxième trame (22) contenant un message d'acquittement.

3. Procédé de synchronisation selon la revendication 2, dans lequel une durée entre l'émission de la première trame (21) et l'émission de la deuxième trame (22) est une durée prédéfinie comprise entre 1 s et 3 s.

4. Procédé de synchronisation selon l'une des revendications précédentes, dans lequel les premières étapes comprennent de plus l'étape, suite à la reconfiguration du premier port (8), d'émettre via le premier port (8), à destination de l'équipement externe (2) et en utilisant la liaison série, une troisième trame (24) contenant une information de fin de mise à l'heure.

5. Procédé de synchronisation selon l'une des revendications précédentes, dans lequel l'interruption est une interruption sur front montant.

6. Procédé de synchronisation selon l'une des revendications précédentes, dans lequel la liaison série est une liaison RS-232.

7. Compteur électrique (1) comprenant une première unité de traitement (5) comportant un premier port (8), dans laquelle sont mises en œuvre les premières étapes du procédé de synchronisation selon l'une des revendications précédentes.

8. Compteur électrique (1) selon la revendication 7, le compteur électrique étant en outre agencé pour surveiller un réseau de distribution d'énergie électrique (3) auquel il est connecté, pour horodater des évènements survenant sur le réseau de distribution d'énergie électrique en utilisant l'heure courante, et pour transmettre à l'équipement externe (2) des informations de surveillance du réseau en utilisant la liaison série.

9. Programme d'ordinateur comprenant des instructions qui conduisent la première unité de traitement (5) du compteur électrique (1) selon l'une des revendications 7 ou 8 à exécuter les premières étapes du procédé de synchronisation selon l'une des revendications 1 à 6.

10. Support d'enregistrement lisible par ordinateur, sur lequel est enregistré le programme d'ordinateur selon la revendication 9.

11. Procédé de synchronisation d'une horloge interne (9) d'un compteur électrique (1) agencé pour être connecté à un équipement externe (2) qui comprend une deuxième unité de traitement (11) comportant un deuxième port (15) agencé pour être connecté au compteur électrique, le procédé de synchronisation comprenant les deuxièmes étapes (E2), mises en œuvre successivement par la deuxième unité de traitement (11) et répétées à intervalles prédéfinis, de :
∘ émettre via le deuxième port (15), à destination du compteur électrique et en utilisant une liaison série, une première trame (21) contenant une heure de référence ;
∘ configurer le deuxième port (15) pour qu'il fonctionne dans un mode de génération d'impulsions ;
∘ émettre via le deuxième port (15), à destination du compteur électrique, une impulsion (23) définissant un temps de synchronisation ;
∘ reconfigurer le deuxième port pour communiquer via le deuxième port en utilisant la liaison série.

12. Procédé de synchronisation selon la revendication 11, dans lequel l'impulsion (23) a une durée définie avec une précision de +/- 1 ms.

13. Procédé de synchronisation selon l'une des revendications 11 ou 12, dans lequel les deuxièmes étapes comprennent de plus l'étape, suite à l'émission de la première trame (21), d'attendre, avant de configurer le deuxième port (15) pour qu'il fonctionne dans le mode de génération d'impulsions, de recevoir via le deuxième port (15) une deuxième trame (22) contenant un message d'acquittement.

14. Modem (2) comprenant une deuxième unité de traitement (11) comportant un deuxième port (15), dans laquelle sont mises en œuvre les deuxièmes étapes du procédé de synchronisation selon l'une des revendications 11 à 13.

15. Programme d'ordinateur comprenant des instructions qui conduisent la deuxième unité de traitement (11) du modem (2) selon la revendication 14 à exécuter les deuxièmes étapes du procédé de synchronisation selon l'une des revendications 11 à 13.

16. Support d'enregistrement lisible par ordinateur, sur lequel est enregistré le programme d'ordinateur selon la revendication 15.

17. Système (0) comprenant un compteur électrique (1) selon l'une des revendications 7 ou 8, et un modem (2) selon la revendication 14.

## Patentansprüche

1. Synchronisationsverfahren zur Synchronisation eines internen Taktgebers (9) eines Stromzählers (1), der eine erste Verarbeitungseinheit (5) mit einem ersten Anschluss (8) enthält, welcher dafür ausgelegt ist, an ein externes Gerät (2) angeschlossen zu werden, wobei das Synchronisationsverfahren die von der ersten Verarbeitungseinheit (5) nacheinander ausgeführten und in vorgegebenen Intervallen wiederholten ersten Schritte (E1) umfasst, dass:
∘ über den ersten Anschluss (8) ein von dem externen Gerät mittels einer seriellen Verbindung übertragener und eine Referenzzeit enthaltender erster Frame (21) empfangen wird;
∘ der erste Anschluss derart konfiguriert wird, dass er in einem Interrupt-Auslösemodus arbeitet;
∘ über den ersten Anschluss ein von dem externen Gerät übertragener und eine Referenzzeit definierender Impuls (23) empfangen wird und ein Interrupt ausgelöst wird, welcher bewirkt, dass zum Zeitpunkt der Synchronisation die Referenzzeit als eine aktuelle Zeit abgespeichert wird;
∘ der erste Anschluss neu konfiguriert wird, sodass unter Verwendung der seriellen Verbindung über den ersten Anschluss kommuniziert wird.

2. Synchronisationsverfahren nach Anspruch 1, wobei die ersten Schritte ferner den Schritt umfassen, dass nach dem Empfang des ersten Frames (21) unter Verwendung der seriellen Verbindung (8) ein zweiter Frame (22), der eine Quittierungsmeldung enthält, über den ersten Anschluss an das externe Gerät übertragen wird.

3. Synchronisationsverfahren nach Anspruch 2, wobei es sich bei der Zeitdauer zwischen der Übertragung des ersten Frames (21) und der Übertragung des zweiten Frames (22) um eine vorgegebene Zeitdauer handelt, die zwischen 1 s und 3 s liegt.

4. Synchronisationsverfahren nach einem der vorhergehenden Ansprüche, wobei die ersten Schritte ferner den Schritt umfassen, dass nach abgeschlossener Neukonfiguration des ersten Anschlusses (8) ein dritter Frame (24), der eine Information über die Beendigung der Zeitstempelaktualisierung enthält, über den ersten Anschluss (8) mittels der seriellen Verbindung an das externe Gerät (2) übertragen wird.

5. Synchronisationsverfahren nach einem der vorhergehenden Ansprüche, wobei es sich bei dem Interrupt um einen Interrupt bei steigender Flanke handelt.

6. Synchronisationsverfahren nach einem der vorhergehenden Ansprüche, wobei es sich bei der seriellen Verbindung um eine RS-232-Verbindung handelt.

7. Stromzähler (1), umfassend eine erste Verarbeitungseinheit (5) mit einem ersten Anschluss (8), in welcher die ersten Schritte des Synchronisationsverfahrens nach einem der vorhergehenden Ansprüche ausgeführt werden.

8. Stromzähler (1) nach Anspruch 7, wobei der Stromzähler ferner dafür ausgelegt ist, ein Stromverteilungsnetz (3), an welches er angeschlossen ist, zu überwachen, in dem Stromverteilungsnetz auftretende Ereignisse unter Verwendung der aktuellen Uhrzeit mit einem Zeitstempel zu versehen, und Netzüberwachungsinformationen mittels der seriellen Verbindung an das externe Gerät (2) zu übertragen.

9. Computerprogramm, das Befehle umfasst, welche die erste Verarbeitungseinheit (5) des Stromzählers (1) nach einem der Ansprüche 7 oder 8 dazu veranlassen, die ersten Schritte des Synchronisationsverfahrens nach einem der Ansprüche 1 bis 6 auszuführen.

10. Computerlesbares Speichermedium, auf welchem das Computerprogramm nach Anspruch 9 abgespeichert ist.

11. Synchronisationsverfahren zur Synchronisation eines internen Taktgebers (9) eines Stromzählers (1), welcher dafür ausgelegt ist, an ein externes Gerät (2) angeschlossen zu werden, das eine zweite Verarbeitungseinheit (11) mit einem zweiten Anschluss (15) umfasst, welcher dafür ausgelegt ist, an den Stromzähler angeschlossen zu werden, wobei das Synchronisationsverfahren die von der zweiten Verarbeitungseinheit (11) nacheinander ausgeführten und in vorgegebenen Intervallen wiederholten zweiten Schritte (E2) umfasst, dass:
∘ ein erster Frame (21), der eine Referenz-Uhrzeit enthält, über den zweiten Anschluss (15) mittels einer seriellen Verbindung an den Stromzähler übertragen wird;
o∘ der zweite Anschluss (15) derart konfiguriert wird, dass er in einem Impulserzeugungsmodus arbeitet;
∘ ein Impuls (23), der eine Synchronisationszeit definiert, über den zweiten Anschluss (15) an den Stromzähler übertragen wird;
∘ der zweite Anschluss neu konfiguriert wird, sodass unter Verwendung der seriellen Verbindung über den zweiten Anschluss kommuniziert wird.

12. Synchronisationsverfahren nach Anspruch 11, wobei der Impuls (23) eine vorgegebene Zeitdauer mit einer Genauigkeit von+/- 1 ms aufweist.

13. Synchronisationsverfahren nach einem der Ansprüche 11 oder 12, wobei die zweiten Schritte ferner den Schritt umfassen, dass nach der Übertragung des ersten Frames (21) gewartet wird, bis über den zweiten Anschluss (15) ein zweiter Frame (22), der eine Quittierungsmeldung enthält, empfangen wird, bevor der zweite Anschluss (15) derart konfiguriert wird, dass er in dem Impulserzeugungsmodus arbeitet.

14. Modem (2), umfassend eine zweite Verarbeitungseinheit (11) mit einem zweiten Anschluss (15), in welcher die zweiten Schritte des Synchronisationsverfahrens nach einem der Ansprüche 11 bis 13 ausgeführt werden.

15. Computerprogramm, das Befehle umfasst, welche die zweite Verarbeitungseinheit (11) des Modems (2) nach Anspruch 14 dazu veranlassen, die zweiten Schritte des Synchronisationsverfahrens nach einem der Ansprüche 11 bis 13 auszuführen.

16. Computerlesbares Speichermedium, auf welchem das Computerprogramm nach Anspruch 15 abgespeichert ist.

17. System (0), umfassend einen Stromzähler (1) nach einem der Ansprüche 7 oder 8 und ein Modem (2) nach Anspruch 14.

## Claims

1. Method for synchronising an internal clock (9) of an electricity meter (1) which comprises a first processing unit (5) comprising a first port (8) arranged to be connected to an external apparatus (2), the synchronisation method comprising the first steps (E1), carried out successively by the first processing unit (5) and repeated at predefined intervals:
∘ receiving, via the first port (8), a first frame (21) that is transmitted by the external apparatus using a serial link and contains a reference time;
∘ configuring the first port to operate in an interrupt-triggering mode;
∘ receiving, via the first port, a pulse (23) that is transmitted by the external apparatus and specifies a synchronisation time, and triggering an interrupt that leads to the reference time being recorded as a current time at the synchronisation time;
∘ reconfiguring the first port so as to communicate via the first port using the serial link.

2. Synchronisation method according to claim 1, wherein the first steps further comprise the step, following the receipt of the first frame (21), of transmitting a second frame (22), which contains an acknowledgement message, to the external apparatus via the first port (8) using the serial link.

3. Synchronisation method according to claim 2, wherein a length of time between the transmission of the first frame (21) and the transmission of the second frame (22) is a predefined length of time between 1 s and 3 s.

4. Synchronisation method according to any of the preceding claims, wherein the first steps further comprise the step, following the reconfiguration of the first port (8), of transmitting a third frame (24), which contains end of time-setting information, to the external apparatus (2) via the first port (8) using the serial link.

5. Synchronisation method according to any of the preceding claims, wherein the interrupt is a rising-edge interrupt.

6. Synchronisation method according to any of the preceding claims, wherein the serial link is an RS-232 link.

7. Electricity meter (1) comprising a first processing unit (8) which comprises a first port (8) and in which the first steps of the synchronisation method according to any of the preceding claims are carried out.

8. Electricity meter (1) according to claim 7, the electricity meter furthermore being arranged to monitor an electric power distribution network (3) to which it is connected, to timestamp events occurring on the electric power distribution network using the current time, and to send network monitoring information to the external apparatus (2) using the serial link.

9. Computer program comprising instructions that cause the first processing unit (5) of the electricity meter (1) according to any of claims 7 or 8 to execute the first steps of the synchronisation method according to any of claims 1 to 6.

10. Computer-readable storage medium on which the computer program according to claim 9 is stored.

11. Method for synchronising an internal clock (9) of an electricity meter (1) arranged to be connected to an external apparatus (2) which comprises a second processing unit (11) comprising a second port (15) arranged to be connected to the electricity meter, the synchronisation method comprising the following second steps (E2), carried out successively by the second processing unit (11) and repeated at predefined intervals:
∘ transmitting a first frame (21), which contains a reference time, to the electricity meter via the second port (15) using a serial link;
∘ configuring the second port (15) to operate in a pulse-generation mode;
∘ transmitting a pulse (23), which specifies a synchronisation time, to the electricity meter via the second port (15);
∘ reconfiguring the second port so as to communicate via the second port using the serial link.

12. Synchronisation method according to claim 11, wherein the pulse (23) has a defined duration with an accuracy of +/- 1 ms.

13. Synchronisation method according to any of claims 11 or 12, wherein the second steps further comprise the step, following the transmission of the first frame (21), of waiting to receive a second frame (22), which contains an acknowledgement message, via the second port (15) before configuring the second port (15) to operate in the pulse-generation mode.

14. Modem (2) comprising a second processing unit (11) which comprises a second port (15) and in which the second steps of the synchronisation method according to any of claims 11 to 13 are carried out.

15. Computer program comprising instructions that cause the second processing unit (11) of the modem (2) according to claim 14 to execute the second steps of the synchronisation method according to any of claims 11 to 13.

16. Computer-readable storage medium on which the computer program according to claim 15 is stored.

17. System (0) comprising an electricity meter (1) according to any of claims 7 or 8 and a modem (2) according to claim 14.
